(19) Europäisches Patentamt
European Patent Office
Office européen des brevets

(11) **EP 4 164 101 A1**

(12) **EUROPEAN PATENT APPLICATION**

(43) Date of publication:
**12.04.2023 Bulletin 2023/15**

(21) Application number: **21201413.8**

(22) Date of filing: **07.10.2021**

(51) International Patent Classification (IPC):
**H02M 1/32** (2007.01)    **H02M 3/158** (2006.01)
**G01R 27/26** (2006.01)    **H02M 1/40** (2007.01)

(52) Cooperative Patent Classification (CPC):
**H02M 1/32; H02M 1/40; H02M 3/1584;**
G01R 27/2611; G01R 31/72

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ABB SCHWEIZ AG
5400 Baden (CH)**

(72) Inventors:
• **Salmia, Teemu
  00380 Helsinki (FI)**
• **Vilkki, Markus
  00380 Helsinki (FI)**
• **Kantola, Timo
  00380 Helsinki (FI)**

(74) Representative: **Kolster Oy Ab
Salmisaarenaukio 1
P.O. Box 204
00181 Helsinki (FI)**

(54) **DC-TO-DC CONVERTER ASSEMBLY**

(57)     A DC-to-DC converter assembly comprising a first direct current connection (11); a second direct current connection (12); a DC-to-DC converter system (2) electrically connected between the first direct current connection (11) and the second direct current connection (12); a controller (909); a choke coil system (4) adapted to limit rate of change of current in the DC-to-DC converter system (2); a voltage measuring system (512) adapted for measuring a voltage of the second direct current connection (12); and a current measuring system (504) adapted for measuring current in the choke coil system (4). The controller (909) is adapted to provide an identification mode for determining at least one electric property of the choke coil system (4), the identification mode comprising supplying a voltage pulse to the choke coil system (4), wherein the identification mode utilizes information received from the voltage measuring system (512) and the current measuring system (504).

Fig. 1

**Description**

FIELD OF THE INVENTION

The present invention relates to a DC-to-DC converter assembly.

BACKGROUND OF THE INVENTION

A known DC-to-DC converter assembly comprises a DC-to-DC converter system and a choke coil system adapted to limit rate of change of current in the DC-to-DC converter system. During normal operation of the assembly, it is controlled such that RMS current in the DC-to-DC converter system is less than or equal to the rated RMS current of the DC-to-DC converter system.

One of the problems associated with the above known DC-to-DC converter assembly is that electric properties of the choke coil system are not accurately known. Saturation of the choke coil system is not supervised, and the choke coils of the choke coil system may fall into a saturated state. The saturated state of the choke coils causes noise and excess warming of the choke coil system. Further, accurately determining an electrical state of the DC-to-DC converter assembly during operation thereof is difficult since it requires information relating to electric properties of the choke coil system. Inaccurate information relating to the electrical state of the DC-to-DC converter assembly may lead, for example, to unnecessary tripping of the DC-to-DC converter system, or to inability to determine whether the DC-to-DC converter assembly operates in a continuous mode or discontinuous mode. Herein, a converter assembly operates in continuous mode if currents through the choke coils of the choke coil system never fall to zero during a commutation cycle.

BRIEF DESCRIPTION OF THE INVENTION

An object of the present invention is to provide a DC-to-DC converter assembly so as to solve the above problems. The objects of the invention are achieved by a DC-to-DC converter assembly which is characterized by what is stated in the independent claim. The preferred embodiments of the invention are disclosed in the dependent claims.

The invention is based on the idea of providing a DC-to-DC converter assembly with a controller adapted to provide an identification mode for determining at least one electric property of the choke coil system, the identification mode comprising supplying a voltage pulse to the choke coil system. The at least one electric property of the choke coil system is determined based on a response the known voltage pulse generates in the DC-to-DC converter assembly, the response being detected by a voltage measuring system and current measuring system inherent in the DC-to-DC converter assembly.

In an embodiment, the at least one electric property of the choke coil system comprises an inductance of the choke coil system. In another embodiment, the at least one electric property of the choke coil system comprises saturation information relating to the choke coil system.

An advantage of the DC-to-DC converter assembly of the invention is that knowledge of the at least one electric property of the choke coil system enables accurately determining an electrical state of the DC-to-DC converter assembly during operation thereof. The knowledge of the at least one electric property of the choke coil system enables controlling the DC-to-DC converter assembly such that the choke coil system does not fall into a saturated state by accident. Further, the knowledge of the at least one electric property of the choke coil system allows the controller of the DC-to-DC converter assembly to carry out accurate calculations relating to apparatuses electrically connected to the DC-to-DC converter assembly.

BRIEF DESCRIPTION OF THE DRAWINGS

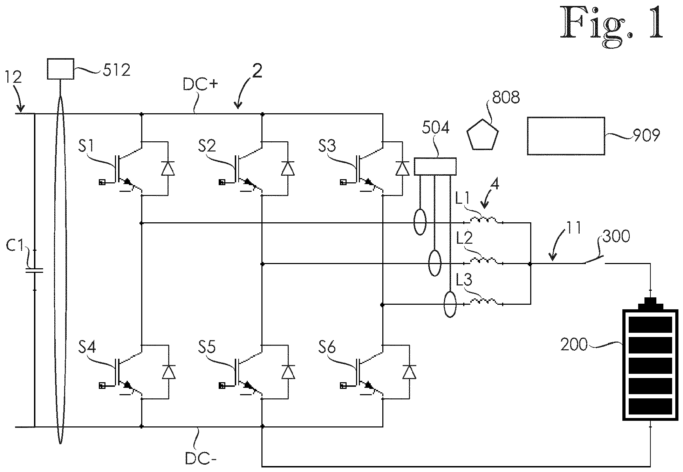

In the following the invention will be described in greater detail by means of preferred embodiments with reference to the attached Figure 1 which shows a circuit diagram of a DC-to-DC converter assembly according to an embodiment of the invention.

DETAILED DESCRIPTION OF THE INVENTION

Figure 1 shows a circuit diagram of a DC-to-DC converter assembly comprising a first direct current connection 11, a second direct current connection 12, a DC-to-DC converter system 2, a choke coil system 4, a controller 909, a data storage system 808, a voltage measuring system 512, a current measuring system 504, and a smoothing capacitor system C1. The DC-to-DC converter system 2 is electrically connected between the first direct current connection 11 and the second direct current connection 12. The DC-to-DC converter system 2 comprises six controllable semiconductor switches S1 to S6. The controller 909 is adapted to control the DC-to-DC converter system 2. The choke coil system 4 is adapted to limit rate of change of current in the DC-to-DC converter system 2. The choke coil system 4 is electrically connected between the first direct current connection 11 and the DC-to-DC converter system 2. The choke coil system 4 comprises three choke coils LI, L2 and L3. The voltage measuring system 512 is adapted for measuring a voltage of the second direct current connection 12. The current measuring system 504 is adapted for measuring current in the choke coil system 4. The voltage measuring system 512 and the current measuring system 504 are in data transfer connection with the controller 909.

The controllable semiconductor switches S1 to S6 form three converter branches such that there are two series-connected semiconductor switches in each of the converter branches. A first converter branch comprises controllable semiconductor switches S1 and S4. A second converter branch comprises controllable semiconductor switches S2 and S5. A third converter branch comprises controllable semiconductor switches S3 and S6. Each of the three converter branches is electrically connected between a positive busbar DC+ and a negative busbar DC-.

A voltage between the positive busbar DC+ and the negative busbar DC- is equal to a voltage of the second direct current connection 12. A nominal voltage of the second direct current connection 12 is 1300V. In an alternative embodiment, a nominal voltage of the second direct current connection is greater than or equal to 10V.

A midpoint of the first converter branch is connected to the first direct current connection 11 through the choke coil L1. A midpoint of the second converter branch is connected to the first direct current connection 11 through the choke coil L2. A midpoint of the third converter branch is connected to the first direct current connection 11 through the choke coil L3. The choke coils LI, L2 and L3 are in star connection.

The smoothing capacitor system C1 is electrically connected to the second direct current connection 12 such that one terminal of the smoothing capacitor system C1 is electrically connected to the positive busbar DC+, and another terminal of the smoothing capacitor system C1 is electrically connected to the negative busbar DC-. A capacitance of the smoothing capacitor system C1 is 5mF. In an alternative embodiment, a capacitance of the smoothing capacitor system is greater than or equal to $10\mu F$.

The controller 909 is adapted to provide an identification mode for determining electric properties of the choke coil system 4. The identification mode comprises supplying a voltage pulse to the choke coil system 4 from the second direct current connection 12. The identification mode utilizes voltage information received from the voltage measuring system 512, and current information received from the current measuring system 504. The electric properties of the choke coil system 4 are determined based on a response the voltage pulse generates in the DC-to-DC converter assembly.

A duration of the voltage pulse is 1ms. In an alternative embodiment, a duration of the voltage pulse is less than or equal to 100ms. A duration of the voltage pulse can be selected based on a periodic time of the DC-to-DC converter system.

The electric properties of the choke coil system 4 determined by the identification mode comprises an inductance of the choke coil system 4, and saturation information relating to the choke coil system 4. In an alternative embodiment, the electric properties of the choke coil system determined by the identification mode comprises an inductance of the choke coil system. In another alternative embodiment, the electric properties of the choke coil system determined by the identification mode comprises saturation information relating to the choke coil system.

The voltage pulse of the identification mode is supplied to the choke coil system 4 by controlling the controllable semiconductor switches of the DC-to-DC converter system 2. For example, by controlling the controllable semiconductor switches S1 and S5 to a conducting state, a current through the choke coils L1 and L2 is generated. Similarly, by controlling the controllable semiconductor switches S2 and S6 to a conducting state, a current through the choke coils L2 and L3 is generated. An inductance of the two series-connected choke coils can be calculated by applying an equation $L = u_{12}dt/di$, where $u_{12}$ is an instantaneous voltage of the second direct current connection 12, dt is a duration of the voltage pulse, and di is the differential of the current passing through the choke coils.

Determining the saturation information relating to the choke coil system 4 comprises supplying a plurality of voltage pulse to the choke coil system 4 in order to define a plurality of inductance values for the choke coil system 4, each of the plurality of inductance values corresponding to a different current value through the choke coil system 4.

Below is a table showing inductance values corresponding to six current values $I_1$ to $I_6$. The current values are determined by the identification mode. In alternative embodiments, number of current values for which inductance values are determined is selected based on required accuracy for the saturation information. The identification mode also comprises storing the determined electric properties of the choke coil system 4 to the data storage system 808.

|  | I [A] | L [$\mu$H] |
|---|---|---|
| $I_1$ | 1000 | 100 |
| $I_2$ | 1100 | 100 |
| $I_3$ | 1200 | 90 |

(continued)

|  | I [A] | L [μH] |
|---|---|---|
| $I_4$ | 1300 | 70 |
| $I_5$ | 1400 | 30 |
| $I_6$ | 1500 | 10 |

Since current values $I_1$ and $I_2$ give the same inductance value, the inductance value in question is a nominal inductance value. An inductance value corresponding to current value $I_6$ is 10% of the nominal value, so it can be considered to be close to null, and the choke coil system 4 can be considered to be in a completely saturated state.

In an alternative embodiment, a plurality of successive voltage pulses are supplied to the choke coil system such that a current value through the choke coil system is raised until a determined inductance value for the choke coil system has decreased at least a predetermined portion compared to the maximum value thereof. Referring to the above table showing inductance values, if the predetermined portion is 20%, the last voltage pulse corresponds to current value $I_4$, and if the predetermined portion is 50%, the last voltage pulse corresponds to current value $I_5$. The maximum value of the inductance is stored as an inductance of the choke coil system, and the current value corresponding to the predetermined decrease of the inductance is stored as the saturation information relating to the choke coil system. Alternatively, it is possible to store a detailed graph representing a saturation behaviour of the choke coil system as a function of current.

The controller 909 is adapted to determine an electrical state of the DC-to-DC converter assembly during operation thereof, and is adapted to use the at least one electric property of the choke coil system 4 for carrying out said determination. The controller 909 is also adapted to use the at least one electric property of the choke coil system 4 in controlling the DC-to-DC converter system 2. During a normal operation of the DC-to-DC converter assembly, the controller 909 is adapted to limit a current of the DC-to-DC converter system 2 based on the saturation information relating to the choke coil system 4 such that the choke coil system 4 does not fall into a saturated state.

There is a direct current supply 200 connected to the first direct current connection 11 through a contactor 300. The controller 909 is adapted to control the contactor 300. In the identification mode, the contactor 300 is kept in a non-conducting state during supplying the voltage pulse.

The at least one electric property of the choke coil system 4 enables the controller 909 to accurately calculate a voltage of the direct current supply 200, and a power of the direct current supply 200.

In an embodiment, the controller is adapted to provide an identification mode for determining an inductance $L_{cs}$ of the choke coil system, and to calculate an estimate $U_{es,est}$ for a voltage of the direct current supply by an equation

$$U_{es,est} = \frac{-U_{dc} \pm \sqrt{U_{dc}^2 + 4 \cdot di \cdot L_{cs} \cdot F_{sw} \cdot U_{dc}}}{-2}$$

in which

   $U_{es,est}$ = the estimate for the voltage of the direct current supply;
   $U_{dc}$ = a voltage of the second direct current connection;
   $di$ = a magnitude of current pulsation, "peak-to-peak" value;
   $L_{cs}$ = the inductance of the choke coil system; and
   $F_{sw}$ = a switching frequency of the DC-to-DC converter system

With the estimate $U_{es,est}$ for the voltage of the direct current supply, the controller is adapted to calculate an estimate $P_{es,est}$ for a power of the direct current supply by an equation $P_{es,est} = U_{es,est} \cdot I_{es}$, in which $I_{es}$ is a current of the direct current supply. The current $I_{es}$ of the direct current supply may be determined by the current measuring system of the DC-to-DC converter assembly, for example.

Based on the estimate $P_{es,est}$ for the power of the direct current supply, the controller is adapted to set a power limit for the direct current supply, which is not allowed to be exceeded. The controller is adapted to limit the power of the direct current supply to a desired value by appropriately controlling the controllable semiconductor switches of the DC-to-DC converter system.

In another embodiment, the controller is adapted to analyse results of the identification mode in order to determine whether components and connections of the choke coil system operate as expected. For example, the identification mode may reveal that choke coils of the choke coil system have different inductances while they should be identical. If the analysis reveals problems, the controller prevents starting of the DC-to-DC converter system and/or notifies an operator of the DC-to-DC converter assembly about the problems.

It will be obvious to a person skilled in the art that the inventive concept can be implemented in various ways. The invention and its embodiments are not limited to the examples described above but may vary within the scope of the claims.

**Claims**

1. A DC-to-DC converter assembly comprising:

   a first direct current connection (11);
   a second direct current connection (12);
   a DC-to-DC converter system (2) electrically connected between the first direct current connection (11) and the second direct current connection (12);
   a controller (909) adapted to control the DC-to-DC converter system (2);
   a choke coil system (4) adapted to limit rate of change of current in the DC-to-DC converter system (2), the choke coil system (4) comprising at least one choke coil (L1, L2, L3);
   a voltage measuring system (512) adapted for measuring a voltage of the second direct current connection (12); and
   a current measuring system (504) adapted for measuring current in the choke coil system (4),
   **characterized in that** the controller (909) is adapted to provide an identification mode for determining at least one electric property of the choke coil system (4), the identification mode comprising supplying a voltage pulse to the choke coil system (4), wherein the identification mode utilizes information received from the voltage measuring system (512) and the current measuring system (504).

2. The DC-to-DC converter assembly according to claim 1, wherein the at least one electric property of the choke coil system (4) comprises at least one of the following: an inductance of the choke coil system (4), and saturation information relating to the choke coil system (4).

3. The DC-to-DC converter assembly according to claim 1 or 2, wherein the DC-to-DC converter system (2) comprises a plurality of controllable semiconductor switches (S1-S6), and the voltage pulse is supplied to the choke coil system (4) by controlling at least part of the plurality of controllable semiconductor switches (S1-S6) to a conducting state.

4. The DC-to-DC converter assembly according to claim 3, wherein the DC-to-DC converter system (2) comprises a positive busbar (DC+) and a negative busbar (DC-), wherein the voltage pulse is supplied to the choke coil system (4) by electrically connecting the positive busbar (DC+) to the negative busbar (DC-) through at least one choke coil (L1, L2, L3) of the choke coil system (4) by means of at least part of the plurality of controllable semiconductor switches (S1-S6).

5. The DC-to-DC converter assembly according to claim 4, wherein there is a smoothing capacitor system (C1) connected electrically between the positive busbar (DC+) and a negative busbar (DC-), a capacitance of the smoothing capacitor system (C1) is greater than or equal to $10\mu F$.

6. The DC-to-DC converter assembly according to any one of the preceding claims, wherein a duration of the voltage pulse is less than or equal to 100ms.

7. The DC-to-DC converter assembly according to any one of the preceding claims, wherein the DC-to-DC converter assembly comprises a data storage system (808), and the identification mode comprises storing at least one electric property of the choke coil system (4) to the data storage system (808).

8. The DC-to-DC converter assembly according to claim 2, wherein the at least one electric property of the choke coil system (4) comprises the saturation information relating to the choke coil system (4), and determining the saturation information comprises supplying a plurality of voltage pulse to the choke coil system (4) in order to define a plurality of inductance values for the choke coil system (4), each of the plurality of inductance values corresponding to a different current value through the choke coil system (4).

9. The DC-to-DC converter assembly according to claim 8, wherein determining the saturation information comprises supplying a plurality of voltage pulse to the choke coil system (4) such that a current value through the choke coil system (4) is raised until a determined inductance value for the choke coil system (4) has decreased at least a predetermined portion compared to the maximum value thereof.

10. The DC-to-DC converter assembly according to claim 9, wherein the predetermined portion is greater than or equal to 20%.

11. The DC-to-DC converter assembly according to any one of the preceding claims, wherein the controller (909) is adapted to determine an electrical state of the DC-to-DC converter assembly during operation thereof, and is adapted to use the at least one electric property of the choke coil system (4) for carrying out said determination.

12. The DC-to-DC converter assembly according to any one of the preceding claims, wherein the controller (909) is adapted to use the at least one electric property of the choke coil system (4) in controlling the DC-to-DC converter system (2).

13. The DC-to-DC converter assembly according to claim 12, wherein during a normal operation of the DC-to-DC converter assembly, the controller (909) is adapted to limit a current of the DC-to-DC converter system (2) based on the at least one electric property of the choke coil system (4).

# Fig. 1

Europäisches
Patentamt

European
Patent Office

Office européen
des brevets

# EUROPEAN SEARCH REPORT

Application Number

**EP 21 20 1413**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 361 554 B1 (DEMSKI JEFFREY [US] ET AL) 23 July 2019 (2019-07-23) * abstract * * column 2, lines 9-19; figures 1-4 * * column 2, line 36 - column 5, line 15 * * column 7, lines 35-57 * * column 9, lines 17, 18 * ----- | 1-13 | INV. H02M1/32 H02M3/158 G01R27/26 H02M1/40 |

TECHNICAL FIELDS
SEARCHED      (IPC)

H02M
G01R

The present search report has been drawn up for all claims

| Place of search | Date of completion of the search | Examiner |
|---|---|---|
| **The Hague** | **15 March 2022** | **Van der Meer, Paul** |

EPO FORM 1503 03.82 (P04C01)

# EP 4 164 101 A1

## ANNEX TO THE EUROPEAN SEARCH REPORT
## ON EUROPEAN PATENT APPLICATION NO.

EP 21 20 1413

15-03-2022

| Patent document cited in search report | Publication date | Patent family member(s) | Publication date |
|---|---|---|---|
| US 10361554      B1 | 23-07-2019 | NONE | |